# EUROPEAN PATENT APPLICATION

(11) **EP 1 207 557 A2**
(43) Date of publication of application: **22.05.2002**
(21) Application number: 01308327.4
(22) Date of filing: 28.09.2001
(51) Int. Cl.: H01L 27/00, H01L 51/40

(54) **Method of attaching layer material and forming layer in predetermined pattern on substrate using mask**

(30) Priority: 28.09.2000 JP 2000296582; 20.09.2001 JP 2001287328
(71) Applicant: Sanyo Electric Co., Ltd., Moriguchi-shi, Osaka (JP)
(72) Inventor: Yamada, Tsutomu, Motosu-gun, Gifu (JP); Yoneda, Kiyoshi, Motosu-gun, Gifu (JP)
(74) Representative: Cross, Rupert Edward Blount

(57) **Abstract**

Upon formation of a layer such as an emissive layer of an organic EL element by attaching an emissive material onto a substrate (10), an evaporation mask (100) including an opening (110) corresponding to the layer formed to have a plurality of individual patterns and having an area, for example, smaller than the substrate is disposed between the substrate (10) and a material source (200). A relative position between the mask (100) and the material source (200), and the substrate (10) is slid by a predetermined pitch corresponding to the size of a pixel of the substrate (10), thereby forming a material layer (such as the emissive layer 64) in a predetermined region of the substrate. As a result, the material layer can be formed on the substrate through, for example, evaporation with a high accuracy.

## Description

### BACKGROUND OF THE INVENTION

### 1. Field of the Invention

The present invention relates to a color display device employing an electroluminescent (hereinafter referred to as "EL") element as an emissive element, and a method of manufacturing such a color display device.

### 2. Description of the Related Art

In recent years, EL display devices comprising EL elements have gained attention as potential replacements for CRTs and LCDs.

Research has been directed to the development of active matrix EL display devices comprising a thin film transistor (hereinafter referred to as a "TFT" ) as a switching element for driving the EL element.

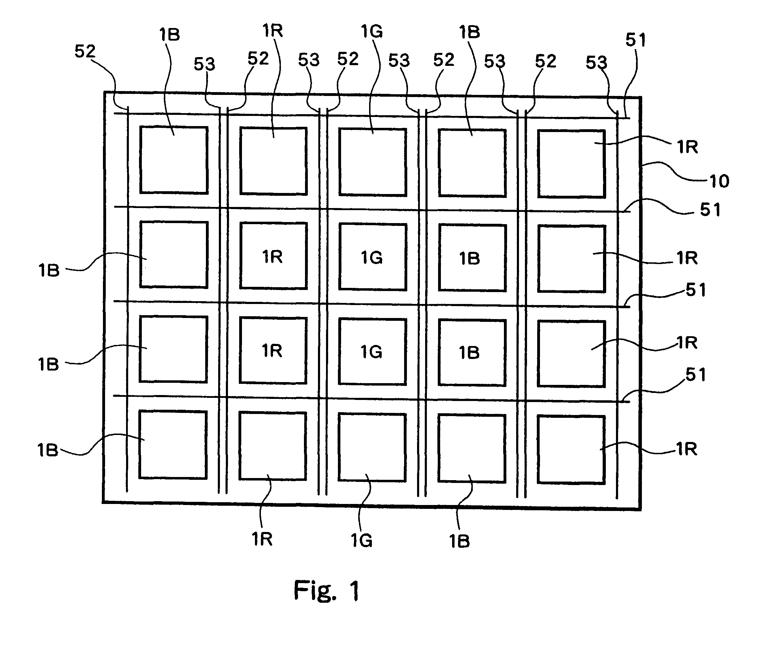

Fig. 1 is a diagram illustrating an arrangement of display pixels 1R, 1G, and 1B for respective colors in a color organic EL display device.

As shown in the figure, the active matrix organic EL display device includes the display pixels 1R, 1G, and 1B for red (R), green (G) , and blue (B) , respectively, which are formed in regions on a substrate 10 surrounded by a gate signal line 51, a drain signal line 52, and a power source line 53. In this example, the display pixels 1R, 1G, and 1B for the respective colors are arranged as stripes in a column direction forming a sequence of R, G, and B in a row direction, collectively constituting a matrix.

The display pixels 1R, 1G, and 1B for the respective colors are each provided with an EL element for emitting the corresponding color of light, namely, R, G, or B.

The EL element formed for each of the respective color display pixels 1R, 1G, and 1B includes an anode formed in the island pattern, an emissive element layer including an organic compound, and a cathode. The emissive element layer includes at least an emissive layer, and is formed by evaporating an organic material onto the anode. On top of this layer, the cathode is formed. The anode of the EL element is connected to a TFT, which individually drives each EL element. By thus controlling the TFT and supplying current between the anode and the cathode, the emissive material contained in the emissive element layer is caused to emit the respective color of light.

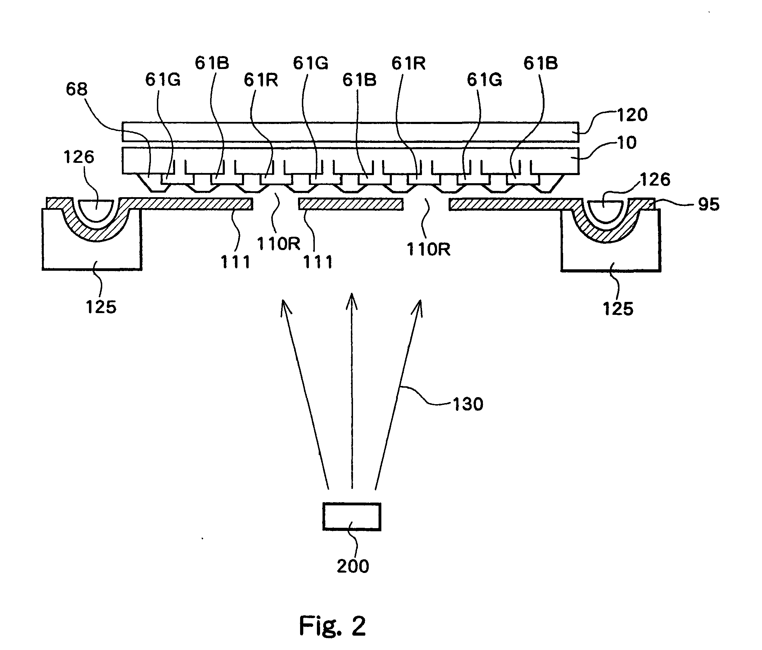

Fig. 2 is a cross sectional view illustrating how a metal mask is mounted for evaporating an organic material for each color onto the glass substrate (the anode) according to a related art. At this stage, the TFT, anodes 61R, 61G, and 61B of organic EL elements 60, and an insulating film 68 covering an area surrounding the anodes are preformed on the glass substrate 10. Although each of the anodes 61R, 61G, and 61B is connected to the TFT for driving the organic EL element, the TFT is not shown for convenience of illustration. This figure illustrates an example in which the organic material for emitting red light is evaporated onto the anode 61R to form the emissive element layer for red.

As shown in Fig. 2, according to the related art, the metal mask 95 used for evaporation of the organic material is a single large mask corresponding to the large-sized glass substrate 10.

A metal mask 95 formed of a metal, such as a nickel (Ni), is fixed into an evaporation mask holder 125 including a mask fixing portion at its periphery, and has an opening 110R at a position corresponding to the anode 61R. The metal mask 95 is placed between the glass substrate 10, having components up to the TFTs and the anodes 61R, 61G, and 61B of the organic EL elements formed thereon with its component bearing side facing downward, and an evaporation source 200 provided further below, as illustrated in Fig. 2. Because the metal mask 95 is very thin, having a thickness of approximately 50 m, when the peripheral portions of the metal mask 95 are placed in grooves formed in the mask fixing portion provided at its periphery to thereby fix the metal mask 95 by means of a fixture 126 provided on the mask, the metal mask 95 is fixed and held in tension applied in the direction of the mask holder 125 to prevent such a thin mask from deflecting. In addition, a magnet 120 is placed on a side of the glass substrate 10 opposite from the side on which the metal mask 95 is arranged, thereby attracting the metal mask 95 and preventing warping thereof.

After the mask 95 and the substrate 10 are thus disposed, an organic material 130 for emitting red light, in this example, is evaporated from the evaporation source 200 onto a region including the anode 61R on the glass substrate 10, thereby depositing the emissive element layer for red color.

After evaporating the organic material for the red emissive element layer, organic materials for the emissive element layers for green and blue are similarly evaporated, thereby forming the emissive element layers for R, G, and B on the respective anodes 61R, 61G, and 61B.

The metal mask 95 used in the related art is a single mask similar in size to the large-sized glass substrate 10, such as 400 mm X 400 mm, and a single, dot-like evaporation source is used as the evaporation source 200.

When a single, large-sized metal mask is thus used, it becomes extremely difficult to form a mask with a high precision as the size of the mask increases, and shadowing, i.e. blocking the evaporated material scattered from the source by the edges of the mask in the openings, also becomes more prominent in the peripheral region of the glass substrate 10.

To overcome such problems, the metal mask must be reduced in thickness to diminish shadowing and be brought into contact with the glass substrate.

However, when the mask is brought into contact with the substrate, the anodes, the organicmaterial, and other components formed on the glass substrate may be damaged by the mask.

### SUMMARY OF INVENTION

The present invention has been conceived in view of the above-described problems, and aims to provide a method of attaching a layer material, such as an emissive material, onto a predetermined position of a substrate with a high precision to form a layer in a desired pattern without generating a scar with a mask and the like.

According to one aspect, the present invention provides a method of forming an individually patterned layer in a plurality of regions of a substrate, comprising the step of disposing between the substrate and a layer material source a mask including an opening corresponding to one or more of the plurality of regions where the layer is formed, and the step of making a relative movement between the mask and the layer material source, and the substrate, and causing a material scattered from the layer material source to attach onto the substrate through the opening, thereby forming the individually patterned layer.

According to another aspect, the present invention provides a method of forming an individually patterned layer in a plurality of regions of a substrate, comprising the step of disposing between the substrate and a layer material source a mask having a smaller area than the substrate and including an opening corresponding to one or more of the plurality of regions where the layer is formed, and the step of causing relative movement between the mask and the layer material source, and the substrate, and causing a material scattered from the layer material source to attach onto the substrate through the opening, thereby forming the individually patterned layer.

According to a further aspect, the present invention provides a manufacturing method of a color emissive device including, on a substrate, a self-emissive element having a first electrode, an emissive material layer for each color, and a second electrode, for each of a plurality of pixels. This manufacturing method comprises the step of disposing between the substrate and an emissive material source a mask including an opening at a position corresponding to a region for forming the emissive material layer of one or more of the plurality of pixels of the substrate, and the step of sliding a relative position between the mask and the emissive material source, and the substrate, by a predetermined pitch corresponding to a size of the pixel of the substrate, and causing an emissive material to attach to a predetermined region of the substrate through the mask, thereby forming the emissive material layer.

According to a further aspect, the present invention provides a manufacturing method of a color emissive device including, on a substrate, a self-emissive element having a first electrode, an emissive material layer for each color, and a second electrode, for each of a plurality of pixels . This manufacturing method comprises the step of disposing between the substrate and an emissive material source a mask including an opening at a position corresponding to a region for forming the emissive material layer of one or more of the plurality of pixels of the substrate, and having a smaller area than the substrate to cover one or more of the plurality of pixels on the substrate, and the step of sliding a relative position between the mask and the emissive material source, and the substrate, by a predetermined pitch corresponding to a size of the pixel of the substrate, and causing an emissive material to attach to a predetermined region of the substrate through the mask, thereby forming the emissive material layer.

According to a further aspect of the present invention, the substrate of the above-described emissive device is slid in two directions of the substrate perpendicular to each other, or in one direction of the substrate by a pitch corresponding to an arrangement of the pixels for a same color.

According to a further aspect of the present invention, the layer material source or the emissive material source is a linearly extending source elongated in a direction perpendicular to a direction of the relative movement between the mask and the layer material source or the emissive material source, and the substrate.

According to a further aspect of the present invention, the linearly extending source is formed by a plurality of layer material sources arranged adjacent to each other.

By thus causing evaporation of a material in a material source while shifting a relative position between the material source and the mask, and the substrate, a material layer can be formed on the substrate through the opening formed in the mask with high positional and patterning accuracies. Because a mask having a smaller area than the substrate is employed as described above, the mask can be provided with a high strength and the opening formed with a high accuracy, and variation in distance between the material source and the respective positions of the mask can be reduced, making it possible to form the material layer at a plurality of positions of the substrate with a very high accuracy and balanced characteristics.

According to a further aspect of the present invention, the layer is an electroluminescent layer formed between first and second electrodes, and the layer material is an electroluminescent material.

According to a further aspect of the present invention, the electroluminescent material is an organic material scattered from the layer material source by evaporation and attached to the substrate, thereby forming the electroluminescent layer.

According to a further aspect of the present invention, the self-emissive element is an electroluminescent element.

According to a further aspect of the present invention, the emissive device is a display device for displaying an image with a plurality of pixels.

As described above, the method according to the present invention allows formation of the individually patterned material layer at predetermined positions of the substrate as desired with a high accuracy. Consequently, emissive material layers for different colors, for example, can be formed with a high accuracy, so that color emissive devices and display devices presenting vivid and uniform colors can be manufactured.

According to a further aspect of the present invention, a semiconductor material is used for the mask.

Use of a semiconductor material for the mask enables formation of the opening by photolithography with a high accuracy and a sufficient strength to be maintained, thereby contributing to improvement in accuracy of patterning the material layer to be formed, and facilitating handling of the mask to, for example, increase life of the mask, so that the cost of manufacturing a device using such a mask can be reduced.

According to a further aspect, the present invention provides a manufacturing method of a display device including, on a substrate, a self-emissive element having a first electrode, an emissive material layer for each color, and a second electrode, for each of a plurality of pixels. This manufacturing method comprises the step of disposing between the substrate and an emissive material source a mask including an individual opening for each pixel corresponding to a region for forming the emissive material layer individually patterned for each of the plurality of pixels, and the step of sliding a relative position between the emissive material source and the substrate and causing an emissive material to attach to a predetermined region of the substrate through the opening of the mask, thereby forming the emissive material layer.

According to a further aspect of the present invention, in the above manufacturing method of a display device, the emissive material source is a linearly extending source elongated in one direction.

Thus, when the emissive material layer is formed in individual patterns forthe respectivepixel regions, theopening corresponding to the individual pattern is formed in the mask, and the material is attached to the substrate while the emissive material source and the substrate are moved relatively. Consequently, the emissive material source is located equally close to each region for forming the emissive material layer on the substrate, thereby preventing variation in thickness of the emissive material layer formed in each of such regions caused by shadowing.

### BRIEF DESCRIPTION OF THE DRAWINGS

Fig. 1 is a plan view illustrating an arrangement of display pixels for respective colors in an EL display device.
Fig. 2 is a cross sectional view illustrating an evaporation method according to a related art.
Fig. 3 is a plan view illustrating an evaporation method according to a first embodiment of the present invention.
Fig. 4 is a cross sectional view illustrating an evaporation method according to the embodiments of the present invention.
Fig. 5 is a plan view illustrating an area surrounding the display pixel of the EL display device.
Figs. 6A and 6B are cross sectional views taken along the lines B-B and C-C in Fig. 5, respectively.
Fig. 7 is a view for explaining a process for evaporating an emissive material onto the respective display pixels of the EL display device.
Fig. 8A is a perspective view illustrating an evaporation method using a mask.
Fig. 8B is a view illustrating a cross sectional structure taken along the line D-D in Fig. 8A.
Figs. 9A, 9B, and 9C are views for explaining an evaporation method according to a second embodiment of the present invention.
Figs. 10A, 10B, and 10C illustrate specific configuration examples of a linearly extending source according to the present invention.

### DESCRIPTION OF PREFERRED EMBODIMENTS

An organic EL display device manufactured by a manufacturing method of a color display device according to the present invention will next be described.

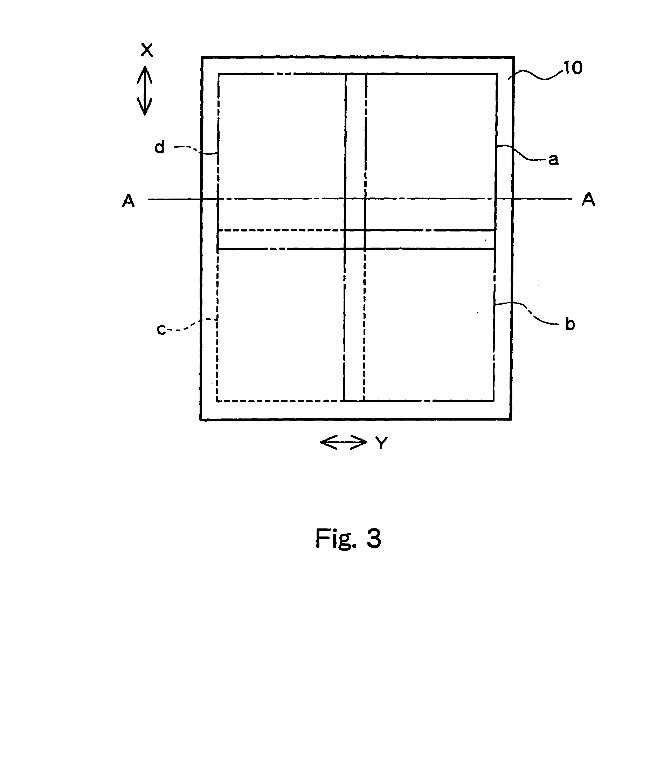

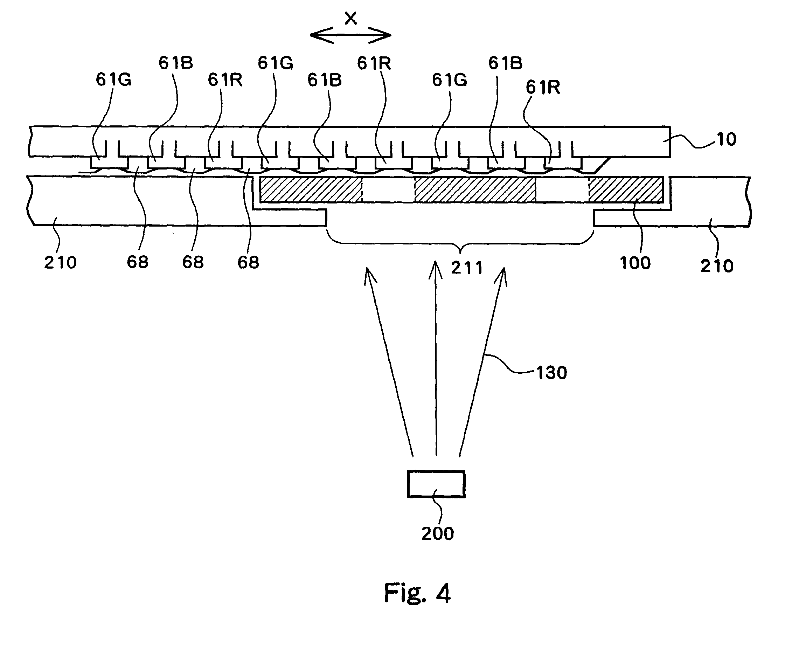

Fig. 3 shows a planar configuration used for explaining a method for moving an insulating substrate onto which an organic material is evaporated according to the present method of manufacturing a color display device, and Fig. 4 shows a cross sectional configuration taken along the line A-A in Fig. 3. It should be noted that Fig. 4 shows the cross section at the step of evaporating an organic emissive material for each color by an evaporation method onto an insulating substrate, such as a glass substrate 10, having components up to a TFT, an anode of an organic EL element, and an insulating film 68 for covering an area surrounding the anode, and that in this particular example an emissive element layer for red is deposited onto an anode 61R through evaporation.

An evaporation mask 100 is disposed between the glass substrate 10 and an evaporation source 200 containing an organic material for the particular color to be evaporated. In contrast to the related art, this evaporation mask 100 has a smaller area than the glass substrate 10 and partially covers the substrate 10. In the region of the glass substrate 10 that is not covered with the evaporation mask 100, a mask supporting member 210 is present. The evaporation mask 100 is supported at an end by the mask supporting member 210 formed of a metal. While an opening 211 is provided at the position of the mask supporting member 210 where the evaporation mask 110 is disposed to allow the evaporated organic material to reach the glass substrate 10 through the evaporation mask 100, in the remaining area the glass substrate 10 is shielded from the evaporation source 200.

As illustrated in the figure, the evaporation source 200 is disposed immediately below the mask 100 so that the material can be efficiently and selectively evaporated onto a restricted area, i.e. the area of the opening formed in the evaporation mask 100 in this example.

Further, in this example, the glass substrate 10 is divided into four evaporation regions "a", "b", "c", and "d" for evaporation of the organic material onto the glass substrate, as illustrated in Fig. 3.

More specifically, after an organic emissive material for red is first evaporated onto the evaporation region "a" (the region defined by the solid line), the glass substrate 10 is slid in the X direction, and the organic emissive material for red is evaporated onto the evaporation region "b" (defined by the one-dot chain line). The glass substrate 10 is then slid in the Y direction, and the red organic emissive material is evaporated onto the evaporation region"c" (defined by the broken line) . Finally, the glass substrate 10 is slid in the X direction, and the red organic emissive material is evaporated onto the evaporation region "d" (defined by the two-dot chain line) . By thus dividing the substrate into a plurality of regions for evaporation, the organic emissive material can be evaporated onto the anode 61R corresponding to the red emissive pixel on the single glass substrate 10 using the evaporation mask 100 having a smaller area than the substrate.

The organic emissive materials for green and blue are each evaporated in a reaction chamber dedicated for each color using a mask dedicated for each color and having a smaller area than the substrate 10 as illustrated in Fig. 4, namely, an evaporation mask for green and an evaporation mask for blue. For such evaporations, the glass substrate 10 is slid in the X and Y directions to evaporate each color onto the respective regions "a", "b", "c", and"d", similarly to evaporation of red. Thus, the organic emissive materials for the respective colors can be evaporated onto the anodes 61R, 61G, and 61B corresponding to the respective colors.

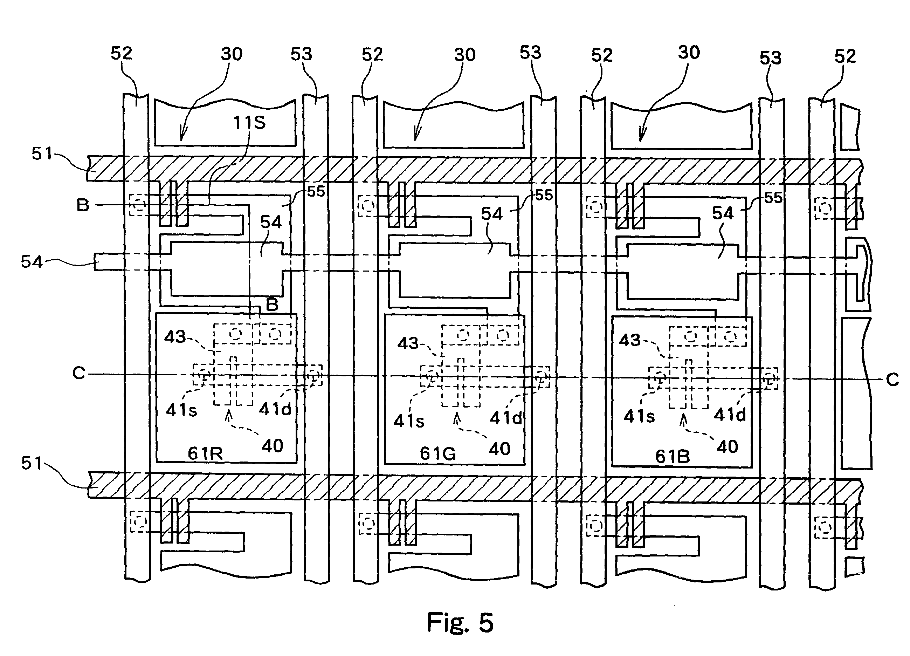

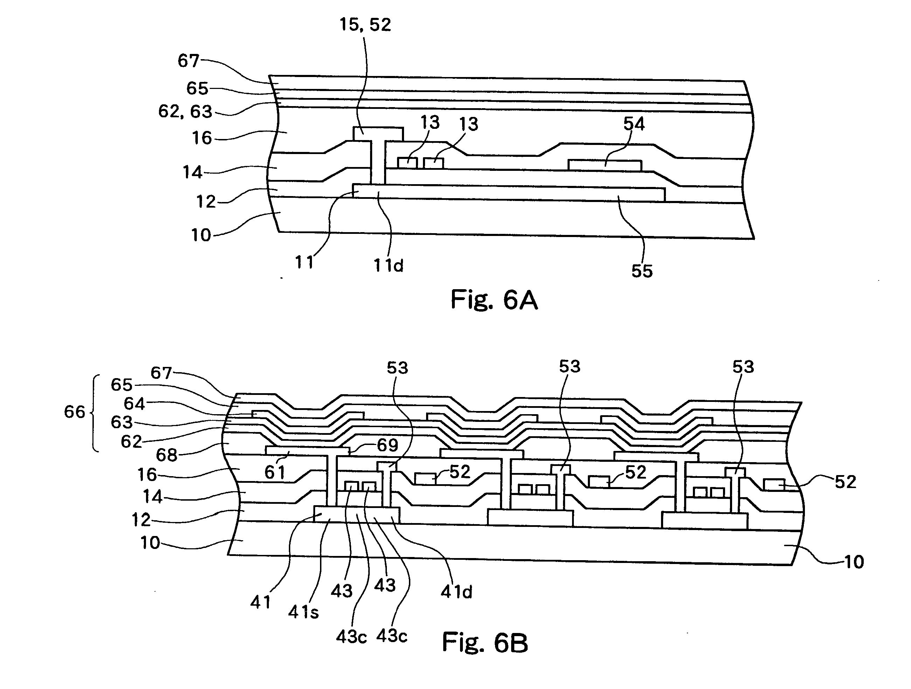

Fig. 5 is a plan view illustrating an area surrounding a display pixel of the organic EL display device, and Figs. 6A and 6B are cross sectional views taken along the lines B-B and C-C, respectively, in Fig. 5.

As shown in Fig. 5, surrounding the region in which each display pixel is formed are gate lines 51 and drain lines 52. A first TFT 30 serving as a switching element is disposed near an intersection of those signal lines. The source 11s of the TFT 30 simultaneously functions as a capacitor electrode 55 such that, together with a storage capacitor electrode line 54 described later, it forms a capacitor. The source 11s is connected to a gate 43 of a second TFT 40 for driving the EL element. The source 41s of the second TFT is connected to the anode 61 of the organic EL element 60. The drain 41d is connected to a power source line 53 which supplies current to the organic EL element 60.

Near the TFT, the storage capacitor electrode line 54 is disposed in parallel to the gate line 51. The storage capacitor electrode line 54 is made of a material such as chromium. The storage capacitor electrode line 54 opposes the capacitor electrode 55 connected to the source 11s of the TFT with a gate insulating film 12 provided in between, and together they form a storage capacitor for storing charges,. This storage capacitor is provided for retaining a voltage applied to the gate electrode 43 of the second TFT 40.

As shown in Figs. 6A and 6B, the organic EL display device is formed by sequentially laminating the TFTs and the organic EL element on the substrate 10 made of a material such as glass or synthetic resin, or on a conductive or semiconductor substrate. It should be noted that the layers and the like formed in the same step are labeled with the same reference numerals in Figs. 6A and 6B.

Next, the first TFT 30, or the switching TFT, will be explained with reference to Fig. 6A.

On the insulating substrate 10 made of quartz glass, non-alkali glass, or a similar material, an amorphous silicon film (a-Si film) is formed using a CVD or other method. The a-Si film is irradiated with an excimer laser beam to be polycrystallized, forming a polycrystalline silicon film (p-Si film) 11 which serves as an active layer of the TFT 30. The gate insulating film 12 is formed over the p-Si film 11. Further on top is disposed the gate signal line 51 which is made of a refractory metal, such as chromium (Cr) or molybdenum (Mo), and which also serves as a gate electrode 13.

An interlayer insulating film 14 of an insulating film, such as an SiO₂ film, is then provided over the entire surface of the gate insulating film 12, the gate electrode 13, the driving power source line 53, and the storage capacitor electrode line 54. A metal such as aluminum (Al) is filled in a contact hole provided corresponding to the drain 11d to form the drain signal line 52, which also serves as a drain electrode 15. Further, a planarizing insulating film 16 made of a photosensitive organic resin or a similar material is formed covering the entire surface for planarization. Further on top, a hole transport layer 63, an electron transport layer 65, and a cathode 67 of the organic EL element 60 are provided over the entire surface.

The second TFT 40, or the TFT for driving the organic EL element, will next be described with reference to Fig. 6B.

As shown in Fig. 6B, sequentially formed on the insulating substrate 10 made of a material such as quartz glass or non-alkali glass are an active layer 41 composed of a p-Si film disposed at the same time with the active layer of the first TFT 30, the gate insulating film 12, and the gate electrode 43 made of a refractory metal such as Cr or Mo. The active layer 41 includes a channel 41c, and, on respective sides of the channel 41c, a source 41s and a drain 41d. The above-described interlayer insulating film 14 composed of an SiN film, and an SiO₂ film stacked in this order is provided on the entire surface over the active layer 41 and the gate insulating film 12. A contact hole formed through the interlayer insulating film 14 and the gate insulating film 12 in a position corresponding to the drain 41d is filled with a metal, such as Al, integrally with the power source line 53 connected to a power source. Further, the planarizing insulating film 16 made of an organic resin or a similar material is formed over the entire surface for planarization. A contact hole is then formed through the planarizing insulating film 16, the interlayer insulating film 14, and the gate insulating film 12 in a position corresponding to the source 41s. A transparent electrode made of ITO (indium tin oxide) that contacts the source 41s through this contact hole, namely, the anode 61 of the organic EL element, is formed on the planarizing insulating film 16.

The organic EL element 60 includes the anode 61 constituted by a transparent electrode made of ITO or a similar material, an emissive element layer 66 composed of a plurality of organic layers, and a cathode 67, which may be composed of a magnesium-indium alloy, stacked in this order. This emissive element layer 66 includes, for example, a first hole-transport layer 62 composed of a material such as MTDATA (4,4,4-tris(3-methylphenylphenylamino)triphenylamine), a second hole-transport layer 63 composed of a material such as TPD (N,N'-diphenyl-N,N'-di(3-methylphenyl)-1, 1'-biphenyl-4,4'-diamine), an emissive layer 64 composed of, for example, Bebq₂ bis (10-hydroxybenzo[h] quinolinato)beryllium) including quinacridone derivatives, and an electron transport layer 65 composed of Bebq₂ or a similar material. All of the above-noted layers of the emissive element layer 66 are laminated on the anode in the described order. An insulating film 68 of a photosensitive organic resin is provided between anodes 61 of the organic EL elements 60 for adjacent pixels and covering an edge 69 of the anode 61, thereby preventing short-circuiting between the edge 69 of the anode 61 and the cathode 67. The organic EL element 60 of the above-described configuration constitutes an emissive region (display region) in each display pixel.

Another example of the structure of the EL element 60 can be constructed by sequentially laminating the layers of (a) transparent layer (anode); (b) ahole transport layer constructed from NBP; (c) an emissive layer including red (R) constructed by doping a red dopant (DCJTB) into a host material (Alq₃), green (G) constructed by doping a green dopant (coumarin 6) into a host material (Alq₃), and blue (B) constructed by doping a blue dopant (perylene) into a host material (BAlq); (d) an electron transport layer constructed from Alq₃; (e) an electron injection layer constructed from lithium fluoride (LiF); and (f) electrode (cathode) constructed from Aluminum (Al). The official names of the above materials described in abbreviations are as follows:
"NBP" : N,N'-Di((naphthalene-1-yl)-N,N'-diphenyl-benzidine);
"Alq₃" : Tris(8-hydroxyquinolinato)aluminum;
"DCJTB" : (2-(1,1-Dimethlethyl)-6-(2-(2,3,6,7-tetrahydro-1,1,7,7 -tetramethyl-1H,5H-benzo[ij]quinolizin-9-yl)ethenyl)-4H-pyr an-4-ylidene)propanedinitrile;
"coumarin 6" : 3-(2-Benzothiazolyl)-7-(diethylamino)coumarin; and
"BAlq" : (1,1'-Bisphenyl-4-0lato)bis(2-methyl-8-quinolinplate-N1,08) Aluminum.
The present invention, however, is not limited to these configurations.

In the organic EL element, holes injected from the anode and electrons injected from the cathode recombine in the emissive layer. As a result, organic molecules contained in the emissive layer are excited, generating excitons. Through the process in which these excitons undergo radiation until deactivation, light is emitted from the emissive layer (emissive material layer) 64. This light radiates outward through the transparent anode 61 via the transparent insulating substrate 10, resulting in light emission.

As illustrated in Fig. 6B, according to the present embodiment, only the emissive layers 64 of the respective organic EL elements 60 are made of different organic materials depending on the color of light to be emitted, and formed in a pattern similar to the anode 61, i.e. in the island pattern. On the other hand, the hole transport layers 62 and 63 and the electron transport layer 65 are formed of the same organic material for all the EL elements 60 for different colors R, G, and B, and shared by all the pixels. In a display device for displaying monochrome images, the emissive layer 64 is formed over the entire surface similarly to the hole transport layers 62 and 63 and the electron transport layer 65 because the layer can be formed of the identical material for all the organic EL elements 60. The hole transport layers 62 and 63 and the electron transport layer 65 may also be formed as individual patterns, as is the emissive layer 64, when, for example, the layers are formed of different materials for the respective pixels in display devices for presenting either a monochrome image or a multi-color image in R, G, and B.

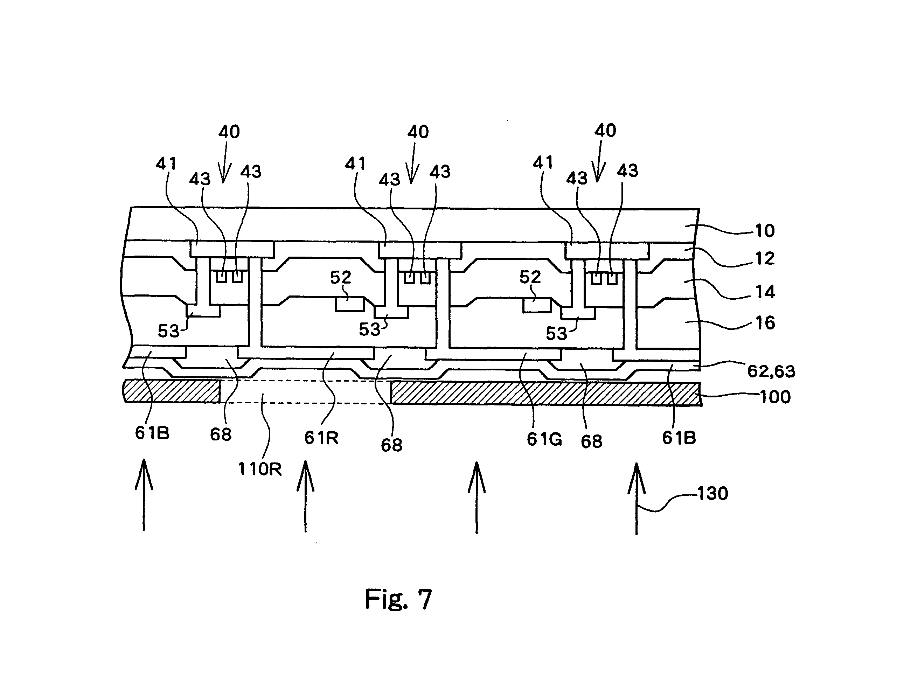

Fig. 7 shows in detail the positional relationship between the evaporation mask 100 and the substrate 10 when the emissive layer 64 is formed through evaporation as individual patterns for the respective organic EL elements 60, and corresponds to the partially enlarged cross sectional view of Fig. 4.

Referring to Fig. 7, on the glass substrate 10 are formed the first and second TFTs and the anodes 61R, 61G, and 61B connected to the second TFT. Further, the insulating film 68 is formed covering the peripheral regions of the anodes 61R, 61G, and 61B, and the hole transport layers 62 and 63 are formed.

Such a glass substrate 10 is introduced into a vacuum evaporation chamber with its anode bearing side facing downward. In this particular example, the evaporation mask 100 having an opening 110R for a region where the emissive layer for red is formed is arranged such that the opening 110R is aligned with the anode 61R of the red display pixel. The organic emissive material for emitting red light is evaporated from an unillustrated evaporation source disposed below the elements in the figure, so that the emissive layer is evaporated onto the anode 61 (more precisely, on the hole electron layers 62 and 63 in Fig. 7) corresponding to the opening 110R of the evaporation mask 100.

The evaporation mask used in the present embodiment will next be described in detail. As described above, the evaporation mask employed in the present embodiment is smaller in size than the substrate 10, and the region of the substrate 10 that is not covered with the evaporation mask is shielded from the evaporation source 201 by the supporting member 210, as illustrated in Fig. 4. According to the present embodiment, a mask smaller than the substrate 10 on which elements are formed is used for the evaporation mask 100. In other words, a small-sized mask that can be formed with a sufficiently high precision can be employed even when the substrate 10 is large. As a result, even when a metal mask of nickel (Ni) or the like is used as in the above description, the present embodiment allows the mask to have a thickness with a sufficient strength and shadowing to be reduced. When the metal mask is used for the evaporation mask in the present embodiment, the mask supporting portion of the supporting member 210 illustrated in Fig. 4 preferably has a fixing mechanism for fixing the metal mask while applying tension thereto in its peripheral direction as illustrated in Fig. 2.

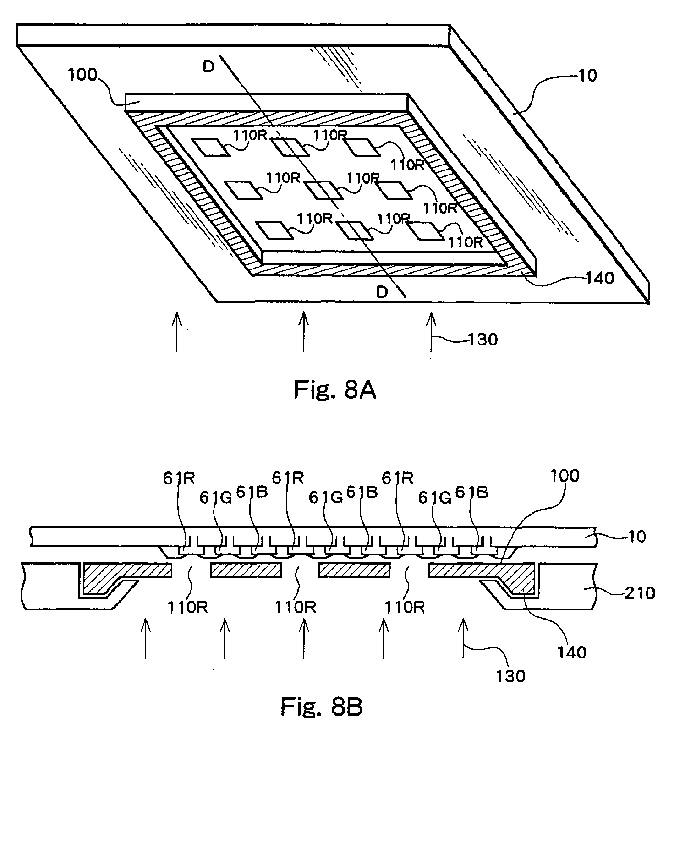

Next, another exemplary evaporation mask will be described with reference to Figs. 8A and 8B. Fig. 8A is a perspective view illustrating the glass substrate 10 in contact with the evaporation mask 100, wherein the glass substrate 10 includes preformed components, namely, the first and second TFTs, the anode 61 and the insulating layer 68 of the organic EL element 60, and the hole transport layer (not shown) shared by all pixels, similarly to the configuration in Fig. 7. Fig. 8B schematically shows cross sectional configurations of the glass substrate 10, the mask 100, and the mask supporting member 210, taken along the line D-D in Fig. 8A.

The evaporation mask 100 illustrated in Figs. 8A and 8B is formed of a monocrystalline silicon (Si) substrate having a thickness of, for example, 0.5 mm, and has a greater thickness portion 140 of 10 m to 50 m in thickness in its peripheral region. While the greater thickness portion 140 is not always necessary, the greater thickness in the peripheral region of the mask 100 contributes to increase in strength of the evaporation mask 100. Such an evaporation mask 100 is disposed in contact with, or close to, a lower surface of the evaporation object, i.e. the glass substrate 10 having the predetermined layers up to those described above. The organic material is evaporated from the unillustrated evaporation source disposed at the lower part of the figure, thereby evaporating the organic material onto the portion of the substrate 10 exposed by the opening 110 of the evaporation mask 100. The evaporation mask 100 in the example of Figs. 8A and 8B is a mask for red color, and, when the pixels for R, G, B are arranged in this sequence in the row direction as illustrated in Fig. 1, the evaporation mask 100 has the openings 110R arranged in the column direction and corresponding to the regions where the organic EL elements for red are formed in every third column.

When the evaporation mask 100 is formed of a silicon substrate as in the present embodiment, the opening for the selective mask can be formed by etching the silicon substrate with the photolithography technique widely used in the art of semiconductor, making it possible to readily form the opening with a high precision. Further, the organic material attached toasurfaceofthesiliconsubstratebyevaporationofthematerial performed a plurality of times using the evaporation mask 100 of the silicon substrate can easily be removed, thereby allowing repeated use of the evaporation mask 100. Because the silicon substrate is highly resistant to etchant used for etching away the organic material attached to the surface, the mask can be more repeatedly used, contributing to reduction in manufacturing cost.

As described above, a mask smaller in size than the glass substrate 10, or the evaporation object, is used, as opposed to the related art in which a single large mask is used for the entire surface of the large-sized glass substrate, whereby the evaporating source can always be disposed immediately under the evaporationmask, that is, relativelyspeaking, immediatelybelow the evaporation region. Consequently, the evaporated material, or the organic material, can always be evaporated to the respective pixel regions (emissive regions) from the vertical direction. This can prevent undesirable evaporation caused by the material scattering around and being deposited on adjacent anodes, and deviation of evaporation position, and avoid shadowing, which is caused by the thickness of the opening of the evaporation mask and by the fact that the evaporated material scatters over a wide area because the evaporation source is not located immediately under the opening.

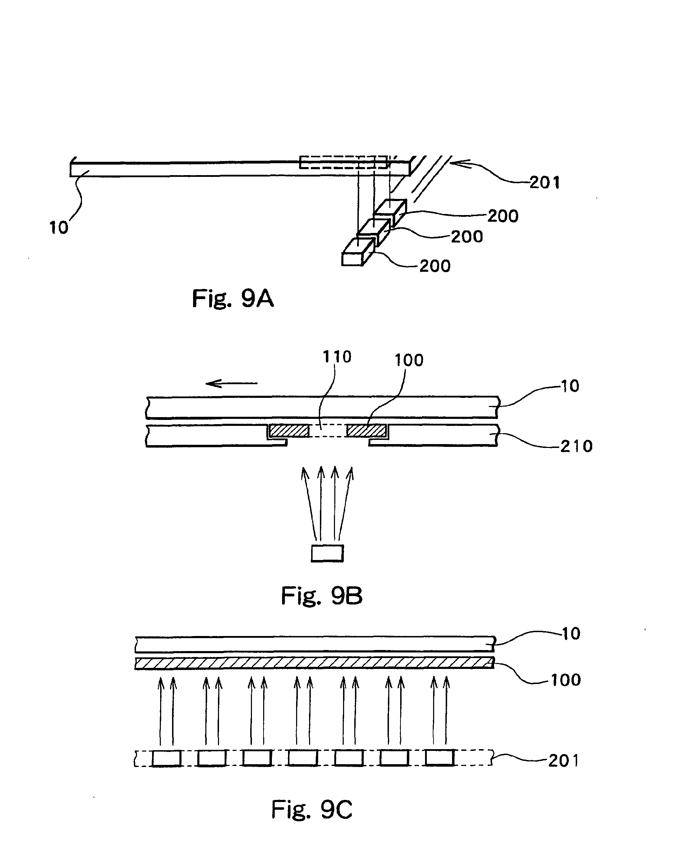

A second embodiment of the present invention will next be described with reference to Figs. 9A-9C. Fig. 9A is a perspective view for explaining the evaporation process, Fig. 9B schematically shows the cross section taken along the line E-E in Fig. 9A, and Fig. C shows the evaporation process of Fig. 9A from the right side. Similarly to the first embodiment, the substrate 10 having the components preformed thereon, namely, the first and second TFTs, the anode of the organic EL element, the insulating layer covering the edge of the anode, and the hole transport layer (when it is formed over the entire surface), is disposed with its element bearing side facing downward. The evaporation mask 100 is disposed on this element bearing side of the substrate 10.

For the evaporation mask 100, a silicon mask formed of a silicon substrate is used similarly to the mask shown in Figs. 8A and 8B (although the metal mask may be used) . The evaporation mask 100 in this example includes openings 110 corresponding to a single column of pixels to serve for the pixel regions for the same color arranged in the column direction on the glass substrate 10. Immediately under such openings 110 of the evaporation mask 100, a plurality of evaporation sources 200 are disposed. The plurality of evaporation sources 200 are arranged in a direction in which the openings 110 of the evaporation mask 100 are arranged, thereby collectively forming a linearly extending source 201 arranged in a straight line in the column direction, as illustrated in Fig. 9C, in this particular example.

As shown in the above-noted figures, the evaporation mask 100 corresponding to a limited set of display pixels is used for evaporation, rather than evaporating the material onto the entire surface of the large glass substrate using a single metal mask as in the related art. Therefore, the evaporation sources can be disposed immediately under the openings 110 of such an evaporation mask, thereby causing the organic material scattered from the evaporation sources 200 with a vertical directivity to attach onto the glass substrate. Consequently, undesirable attachment of the organic material onto adjacent anodes and deviation of position at which the emissive layer is formed can be prevented.

For evaporating the evaporation material from the evaporation source onto the glass substrate 10, in this example the glass substrate 10 is slid by a predetermined pitch from the right to the left in the figure, i.e. in the direction along a pair of sides of the substrate 10 or along the row of the matrix on the substrate 10, or in the direction perpendicular to the direction in which the openings 110 of the evaporation mask 100 and the linearly extending source 201 are arranged. Alternatively, the evaporation mask 100 and the evaporation sources 200 may be moved relative to the substrate 10, rather than moving the substrate 10, while maintaining the positional relationship between the openings 110 of the evaporation mask 100 and the respective evaporation sources 200. In either case, the openings 110 of the evaporation mask 100 and the evaporation sources 200 are arranged in a direction perpendicular to the direction of relative movement between the substrate 10, and the evaporation mask 100 and the evaporation sources 200.

The method of sliding the glass substrate 10 will next be described. The opening 110 of the evaporation mask 100 is first aligned with the red display pixel 1R in a given column, and the organic material for red is evaporated from the evaporation source 200. The glass substrate 10 is then slid by a predetermined pitch (every third column, for example, when the pixels for R, G, B are arranged as stripes in this order), so that the evaporation mask 100 is aligned with the red display pixel 1R in the next red column and the red organic material is evaporated. By repeatedly performing such evaporation and substrate sliding steps, the organic material for red can be evaporated onto each anode for the red display pixels formed on the glass substrate 10. Upon positioning of the evaporation mask 100, when the precision in alignment between the evaporation mask 100 and the anode on the substrate 10 can be maintained, the mask 100 must be aligned therewith only for the first evaporation, and it is not necessary to align these elements every time the substrate 10 is slid. Such an approach is preferable because it contributes to improvement in throughput of the process.

Evaporation for the green and blue display pixels 1G and 1B, respectively, arranged in the column direction next to the red display pixel 1R as shown in Fig. 1 can be performed in a similar manner to the evaporation for red. More specifically, the glass substrate 10 is slid, and evaporation is sequentially performed from the anode on one side of the substrate 10 to the anode on the other side thereof. Thus, the organic materials for the respective colors can be provided on the anodes 61R, 61G, and 61B corresponding to the respective display pixels 1R, 1G, and 1B.

As illustrated in Fig. 9B, the evaporation mask 100 is fixed to the supporting member 210 having an opening in a region for disposing the evaporation mask as that shown in Fig. 4, and the region of the substrate 10 that is not covered with the evaporation mask 100 is shielded from the evaporation source 200 by the supporting member 210.

The evaporation mask 100 may have more than one column of openings 110 (only for the pixels of the identical color), rather than a single column of openings as illustrated in Fig. 9A. When the openings 110 are provided in an increased number of columns, however, the evaporated material scatters obliquely for the opening 110 formed at a position distant from the linearly extending source 201 extending in the column direction. Therefore, the number of columns of the openings 110 in a single evaporation mask 100 is preferably determined taking into consideration the distance between the evaporation source 200 and the glass substrate 10, and the scattering direction of the evaporated material.

Further, similarly to the number of columns described above, the number of openings 110 provided in the evaporation mask 100 may not be the same as the total number of anodes arranged in one column among the anodes for a plurality of pixels on the glass substrate 10 as illustrated in Fig. 9A, and may be smaller than this number. When such a smaller number of openings are provided, an evaporation mask 100 that is smaller in size in both row and column directions than the large-sized substrate 10 of, for example, 400 mm X 400 mm is used. The evaporation mask 100 and the substrate 10 are first arranged such that some of the anodes of pixels in the column direction overlap the openings 110 of the mask 100. The substrate 10 is then sequentially slid to the end in the row direction while the organic layer is formed by evaporation. Next, the relative position between the substrate 10 and the mask 100 is shifted in the column direction by the distance corresponding to the number of openings 110 provided in the mask 100, and the substrate 10 is again slid in the row direction while the evaporation process is performed. Such a procedure is repeatedly conducted until the organic layer is evaporated onto all of the necessary pixel regions on the substrate.

The number of columns of the openings 110 of the evaporation mask 100 and the number of openings in a column are preferably maximized while suppressing shadowing by the evaporation mask 100 caused by the evaporatedmaterial from the evaporation source 200 being scattered in an oblique direction, and undesirable evaporation onto other pixels. This is because a larger number of openings 110 result in a wider area to be evaporated by a single evaporation, leading to a higher throughput of the evaporation process.

When a plurality of evaporation sources 200 are arranged in the column direction to form a linearly extending source 201 as illustrated in Fig. 9A and the size of the evaporation mask 100 is the same, shadowing or undesirable evaporation onto other pixels can significantly be reduced as compared to the case where the organic layer is formed by evaporation onto the anodes for a plurality of pixels by a single (dot-like) evaporation source 200. This is because, as the evaporation sources are arranged in the column direction by employing the linearly extending source 201 as illustrated in Fig. 9C, the evaporation material is scattered more vertically, thereby making uniform the direction of the scattering evaporation material from the evaporation mask 100 to the respective openings 110.

It should be noted that the organic materials having, for example, an emissive function and used for the organic EL elements for the respective colors are evaporated onto the pixel regions for the corresponding colors in different chambers (chambers where different evaporation sources are set) using different masks.

Next, the movement pitch of the above-described substrate 10 when the substrate is slid will be described.

When the openings of the evaporation mask 100 are arranged in a direction perpendicular to the sliding direction of the substrate 10 as described above and the display pixels 1R, 1G, and 1B are arranged as stripes as shown in Fig. 1, the openings 110 of the evaporation mask 100 are moved to every third column corresponding to, for example, the repeatedly arranged display pixels 1R, skipping the display pixels 1G and 1B. Thus, the sliding pitch corresponds to 3 columns when the arrangement as shown in Fig. 1 is employed. More precisely, the process can be performed by sliding the substrate 10, or changing the relative position between the substrate and the evaporation mask 100, corresponding to the repeatedly arranged red display pixels 1R.

As described above, according to the second embodiment of the present invention, the evaporation mask 100 smaller in size than the substrate 10 is employed to evaporate the organic material for the identical color onto the substrate 10 a plurality of times. Further, the linearly extending source 210 extending in the direction in which the evaporation mask 100 is provided is employed. As a result, variation in evaporating conditions for the respective openings 110 is reduced, thereby preventing variation in thickness of the evaporation layer. Consequently, problems, such as variation in tone of the same color between the central portion and the peripheral portion of the glass substrate 10, can be avoided, and the organic material to be evaporated onto a given anode is prevented from reaching and being attached onto the adjacent anodes for different color pixel regions, thereby preventing blurring caused by color mixture.

Further, flexure of the evaporation mask 100 according to the second embodiment is very small because a sufficient strength is provided to the mask. This feature further ensures prevention of problems, such as the opening 110 and the metal mask 100 becoming misaligned from the central portion toward the peripheral portion of the mask 100. Such a misalignment shifts the position where the emissive material is actually evaporated from the anode 61 onto which the organic material must be evaporated, as a result of which a given color cannot be emitted in the EL display device. As a result, color blurring can be eliminated and vivid display of a desired color can be achieved.

While in the above-described first and second embodiments only several openings of the evaporation mask are illustrated for clarity of illustration, in actual fact more openings are formed. When, for example, a plurality of display device regions are simultaneously formed on the same substrate 10, the openings are formed in a number corresponding to (e.g. the total number or a submultiple of) display device regions having the pixels of, for example, 852 (columns) X 222 (rows).

Further, while in the above-described first embodiment the single large substrate 10 is divided into four evaporation regions as shown in Fig. 3, naturally the number by which the substrate is divided is not limited to four in the present invention. However, because the insulating substrate is slid in vertical and horizontal directions of Fig. 3 (X and Y directions, respectively) for evaporation, this number is preferably an even number in light of the evaporation process efficiency.

While the display pixels for the respective colors are described as being arranged as stripes in the above embodiments, other arrangements are also possible, and the present invention can also be applied to a display device having display pixels in the so-called delta arrangement or in a variety of other arrangements. Insuchacase, the present invention can be readily implemented by using an evaporation mask having openings corresponding to the arrangement of the respective color display pixels.

Further, as described in connection with the second embodiment, the number of evaporation sources disposed below the evaporation mask may be set such that the organic material scattered onto the glass substrate has the directivity as close as possible to the right angle to the substrate. More specifically, the number may be determined in accordance with the distance between the glass substrate and the evaporation source, and with a predetermined thickness of the organic material layer formed on the anode. It should be noted, however, that, when a plurality of separate evaporation sources are arranged, the organic material can be efficiently and uniformly evaporated to the respective openings by providing one evaporation source for each opening, or providing as many evaporation sources as possible if such a one-on-one provision is impossible.

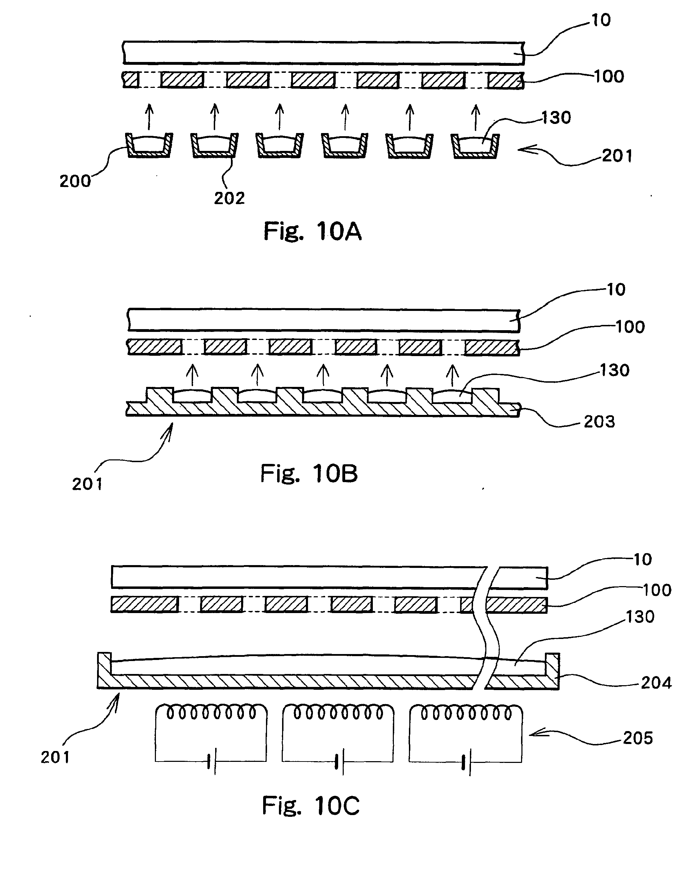

Next, a specific example and variations of the linearly extending source employed in the above-described second embodiment will be described with reference to Figs. 10A-10C. Fig. 10A illustrates a more specific configuration of the linearly extending source 201 shown in Fig. 9A. Referring to Fig. 10A, each evaporation source 200 is formed by a container 202 containing the evaporation material (such as emissive material) 130, and such sources are linearly arranged to constitute the linearly extending source 201. It should be noted that each evaporation source 200 can heat the evaporation material 130 by means of an unillustrated individual heater. The linearly extending source 201 illustrated in Fig. 10B includes a plurality of material cells formed in a single container 203, each containing the evaporation material 130. One or more unillustrated heaters heat the evaporation material 130 in each material cell to cause evaporation. As described above, each material cell may be disposed corresponding to the position of the opening 110 in the mask 100, or to a plurality of openings 110. The linearly extending source 201 illustrated in Fig. 10C is formed by a single container 204 elongated in one direction and containing the evaporation material 130. A plurality of heaters 205 are provided to heat and evaporate the evaporation material 130.

The structure in Fig. 10A is advantageous in that the independently provided evaporation source 200 can be individually controlled, and that the evaporation source 200 with a malfunction can be individually replaced. Because a single container 203 is employed for the linearly extending source 201 illustrated in Fig. 10B, the source can be easilymoved or heated, facilitating the control. In addition, the container 203 can be designed such that the material cell is placed corresponding to each opening 110 of the mask 100 to the greatest extent possible, as illustrated, thereby reducing the amount of material scattered from the evaporation source to the region where the opening is not provided, and achieving a high efficiency in use of the material similarly to the linearly extending source 201 in Fig. 10A. The linearly extending source 201 illustrated in Fig. 10C can be easily controlledupon, for example, movement because a single container 204 is employed. Byusingapluralityofheaters205asillustrated in Fig. 10C, the optimum heating environment can be realized by individually controlling the respective heaters 205, and, when some of the heaters 205 break down, the rest of the heaters 205 can heat the evaporation material 130 compensating for the failed heaters.

As described above, the differently configured sources 201 extending in a linear manner have different characteristics. By choosing an appropriately configured source 201 for the particular use, the evaporation process can be smoothly performed, and reduction in cost and improvement in accuracy can be achieved.

The mask 100 having an smaller area than the substrate 10 is employed in the above description. When the linearly extending source 201 as illustrated in Figs. 10A-10C is employed and moved relative to the substrate, a uniform evaporation layer can be formed in each region even by employing, for example, a mask similar in size to the substrate 10 and having a plurality of openings corresponding to the individual patterns of the evaporation layer for the plurality of pixels on the substrate 10. When the openings 110 are formed in the individual patterns in the mask corresponding to the respective pixels, greater effects of shadowing and the like are observed in the openings 110 located farther from the evaporation source if the relative position between the evaporation source and the substrate remains unchanged. However, by employing the relatively large source 201 extending in a linear manner as illustrated in Figs . 10A-10C, and moving the source 201 or the substrate 10 and the mask 100 fixedly aligned with the substrate 10, the source can be positioned equally close to the respective regions for forming the evaporation layer on the substrate 10, and in particular the source always passes immediately below each region. Consequently, the individually patterned evaporation layer can be uniformly formed for each pixel on the substrate. When the throughput of the evaporation process is sufficiently high, a single dot-like evaporation source 200 may be used and moved relative to the substrate 10 rather than using the large linearly extending source 201. With any of the above-described sources, a large-sized mask 100 may also be used as long as inaccurate positioning of the opening 110 with respect to the evaporation layer formation region due to flexure and the like can be avoided.

Although the display device has been described as being an active matrix display device including a TFT for each pixel as a switching element, the switching element is not limited to a TFT and may be a diode or the like. Further, the display device is not limited to the active matrix color display device, and the present invention may be applied to formation of an individual evaporation layer for each pixel, column, or row of a substrate having a large area in a passive matrix display device where a switching element is not formed for each pixel. In other words, by employing an evaporation mask smaller than the large-sized substrate and causing relative movement between the evaporation mask and the evaporation source, and the substrate, a uniform evaporation layer can be accurately formed at any position of the substrate.

Further, while organic EL display devices are described in the above-described embodiments, the present invention is not limited thereto, and is also applicable to a commonly used vacuum fluorescent display (VFD) including self-emissive elements. In a VFD, an anode, a filament, and a fluorescent material layer provided on the anode correspond to an anode, a cathode, and an emissive element layer of an organic EL element, respectively. When the present invention is applied to a VFD, the material is attached using a mask having an opening at a position corresponding to the fluorescent material layer of a predetermined color. For such attachment, the glass substrate onto which the fluorescent material is attached is slid by the pitch corresponding to a predetermined number of display pixels.

## Claims

1. A method of forming an individually patterned layer in a plurality of regions of a substrate, comprising the steps of:
disposing between said substrate and a layer material source a mask including an opening corresponding to one or more of the plurality of regions where said layer is formed; and
causing relative movement between said mask and said layer material source, and said substrate, and causing a material scattered from said layer material source to attach to said substrate through said opening, thereby forming said individually patterned layer.

2. A method of forming an individually patterned layer in a plurality of regions of a substrate, comprising the steps of:
disposing between said substrate and a layer material source a mask having a smaller area than said substrate and including an opening corresponding to one or more of the plurality of regions where said layer is formed; and
causing relative movement between said mask and said layer material source, and said substrate, and causing a material scattered from said layer material source to attach to said substrate through said opening, thereby forming said individually patterned layer.

3. A method according to claim 1 or 2, wherein
said layer material source is a linearly extending source elongated in a direction perpendicular to a direction of the relative movement between said mask and said layer material source, and said substrate.

4. A method according to claim 3, wherein
said linearly extending source is formed by a plurality of layer material sources arranged adjacent to each other.

5. A method according to any one of claims 1-4, wherein
said layer is an electroluminescent layer formed between first and second electrodes, and
said layer material is an electroluminescent material.

6. A method according to claim 5, wherein
said electroluminescent material is an organic material scattered from said layer material source by evaporation and attached to said substrate, thereby forming said electroluminescent layer.

7. A manufacturing method of a color emissive device including, on a substrate, a self-emissive element having a first electrode, an emissive material layer for each color, and a second electrode, for each of a plurality of pixels, said method comprising the steps of:
disposing between said substrate and an emissive material source a mask including an opening at a position corresponding to a region for forming the emissive material layer of one or more of said plurality of pixels of said substrate; and
sliding a relative position between said mask and said emissive material source, and said substrate, by a predetermined pitch corresponding to a size of the pixel of said substrate, and causing an emissive material to attach to a predetermined region of said substrate through said mask, thereby forming the emissive material layer.

8. A manufacturing method of a color emissive device including, on a substrate, a self-emissive element having a first electrode, an emissive material layer for each color, and a second electrode, for each of a plurality of pixels, said method comprising the steps of:
disposing between said substrate and an emissive material source a mask including an opening at a position corresponding to a region for forming the emissive material layer of one or more of said plurality of pixels of said substrate, and having a smaller area than said substrate to cover one or more of said plurality of pixels on said substrate; and
sliding a relative position between said mask and said emissive material source, and said substrate by a predetermined pitch corresponding to a size of the pixel of said substrate, and causing an emissive material to attach to a predetermined region of said substrate through said mask, thereby forming the emissive material layer.

9. A manufacturing method of a color emissive device according to claim 7 or 8, wherein
said substrate is slid in two directions of said substrate perpendicular to each other by a pitch corresponding to an arrangement of said pixels for a same color.

10. A manufacturing method of a color emissive device according to claim 7 or 8, wherein
said substrate is slid in one direction of said substrate by a pitch corresponding to an arrangement of said pixels for a same color.

11. A manufacturing method of a color emissive device according to any one of claims 7-10, wherein
said emissive material source is a linearly extending source elongated in a direction perpendicular to a direction of the relative movement between said mask and said emissive material source, and said substrate.

12. A manufacturing method of a color emissive device according to claim 11, wherein
said linearly extending source is formed by a plurality of emissive material sources arranged adjacent to each other.

13. A manufacturing method of a color emissive device according to any one of claims 7-12, wherein
said self-emissive element is an electroluminescent element.

14. A manufacturing method of a color emissive device according to any one of claims 7-13, wherein
said emissive device is a display device for displaying an image with a plurality of pixels.

15. A method or a manufacturing method according to any one of claims 1-13, wherein
a semiconductor material is used for said mask.

16. A manufacturing method of a display device including, on a substrate, a self-emissive element having a first electrode, an emissivematerial layer for each color, and a second electrode, for each of a plurality of pixels, said method comprising the steps of:
disposing between said substrate and an emissive material source a mask including an individual opening for each pixel corresponding to a region for forming the emissive material layer individually patterned for each of said plurality of pixels; and
sliding a relative position between said emissive material source and said substrate and causing an emissive material to attach to a predetermined region of said substrate through the opening of saidmask, thereby forming the emissive material layer.

17. A manufacturing method of a display device according to claim 16, wherein
said emissive material source is a linearly extending source elongated in one direction.
